# EUROPÄISCHE PATENTSCHRIFT

(11) **EP 0 508 268 B1**
(45) Veröffentlichungstag und Bekanntmachung des Hinweises auf die Patenterteilung: **23.12.1998**
(21) Anmeldenummer: 92105466.4
(22) Anmeldetag: 30.03.1992
(51) Int. Cl.: G03F 7/022

(54) **Naphthochinondiazid-sulfonsäure-Mischester enthaltendes strahlungsempfindliches Gemisch und damit hergestelltes strahlungsempfindliches Aufzeichnungsmaterial**
Radiation-sensitive composition comprising naphthoquinone-di-azide-sulfonic acid esters and recording material produced therewith
Composition sensible aux radiations comprenant un mélange d'esters de l'acide naphtoquinone diazide sulfonique et matériel d'enregistrement à base de cette composition

(30) Priorität: 09.04.1991 DE 4111444
(43) Veröffentlichungstag der Anmeldung: 14.10.1992
(73) Patentinhaber: Clariant GmbH, 65929 Frankfurt am Main (DE)
(72) Erfinder: Scheler, Siegfried, Dr., W-6200 Wiesbaden-Naurod (DE); Zahn, Wolfgang, Dr., W-6228 Eltville 2 (DE); Schmitt, Axel, Dr., W-6229 Walluf (DE); Buhr, Gerhard, Dr., W-6240 Königstein (DE)

(56) Entgegenhaltungen:
- EP-A- 369 219
- DE-A- 3 839 906
- US-A- 4 871 645

## Beschreibung

Die Erfindung betrifft ein strahlungsempfindliches Gemisch, das ein in Wasser unlösliches, in wäßrig-alkalischen Lösungen jedoch lösliches, zumindest aber quellbares harzartiges Bindemittel und mindestens eine strahlungsempfindliche Verbindung enthält.

Die strahlungsempfindliche Schicht üblicher Kopiermaterialien besteht im wesentlichen aus einem Gemisch eines alkalilöslichen Kresol-Formaldehyd-Novolaks und strahlungsempfindlichen Verbindungen, wie 1,2-Benzo- oder o-Naphthochinon-2-diazidderivaten. Der Novolak ist an sich in wäßrig-alkalischen Lösungen löslich, doch wirken die strahlungsempfindlichen o-Chinondiazidverbindungen als Lösungshemmer. Bei der bildmäßigen Belichtung der Schicht mit aktinischer Strahlung wird die strahlungsempfindliche Diazo-carbonyl-Verbindung über ein Keten-Zwischenprodukt in eine Carbonsäure umgewandelt. Die Carbonsäure ist leicht löslich in wäßrig-alkalischer Lösung und verstärkt damit noch die Löslichkeit des Novolaks. Die Herstellung von Novolaken ist beispielsweise von A. Knop und W. Scheib in "Chemistry and Application of Phenol Resins", Kapitel 4, Springer-Verlag, New York 1979, beschrieben.

Die belichteten Bereiche der Kopierschicht lösen sich in der alkalischen Entwicklerlösung, während die nicht belichteten Bereiche im wesentlichen unverändert erhalten bleiben, so daß auf dem Schichtträger ein positives Reliefbild der Vorlage entsteht.

Das beschriebene Löslichkeitsverhalten läßt sich jedoch auch umkehren. Dazu wird die Aufzeichnungsschicht nach der bildmäßigen Bestrahlung einer Wärmebehandlung unterzogen. In den vom Licht getroffenen Bereichen der Schicht vernetzen dabei die Harzmoleküle der Schicht. Dieser als "Härtung" bezeichnete Vorgang setzt in der Regel das Vorhandensein eines "Vernetzers" voraus, der unter dem Einfluß der Säure, die bei der Belichtung aus dem o-Chinondiazid entstanden ist, während der Wärmebehandlung die Vernetzung und damit die Härtung bewirkt. Beim Härten wird auf Temperaturen unterhalb der Zersetzungstemperatur des o-Chinondiazids erwärmt. Das Erwärmen kann durch Bestrahlen, Einbringen in einen Strom heißen Gases, Kontakt mit erwärmten Flächen, z. B. mit beheizten Walzen, oder durch Tauchen in ein erwärmtes Bad einer inerten Flüssigkeit, z. B. Wasser, erfolgen. Die Temperatur liegt im allgemeinen zwischen 100 und 150 °C, vorzugsweise zwischen 90 und 130 °C.

Wirksame Vernetzer sind allgemein Verbindungen, die unter den beschriebenen Säure- und Temperaturverhältnissen leicht ein Carboniumion bilden. Beispiele hierfür sind die Hexamethylolmelaminether gemäß DE-A 33 25 022 (= US-A 4 581 321) sowie die in der EP-A 0 212 482 beschriebenen Verbindungen, wie 1,4-Bis-hydroxymethylbenzol und 4,4'-Bis-methoxymethyldiphenylether, in denen zwei oder mehr aromatisch gebundene Hydroxymethyl- oder Alkoxymethylgruppen enthalten sind. Als Vernetzer ist auch 2,6-Bis-hydroxymethyl-4-methyl-phenol gemäß US-A 4 404 272 bekannt.

Nach der Wärmebehandlung wird die Photoresistschicht in der Regel einer vollflächigen Belichtung ("Flutbelichtung") unterworfen, um die noch strahlungsempfindlichen Schichtbereiche vollständig alkalilöslich zu machen.

Die Flutbelichtung erfolgt im allgemeinen mit der gleichen Lichtquelle, die auch für die Bildbelichtung verwendet wurde.

Die Entwicklung im Anschluß an die Flutbelichtung wird im allgemeinen mit einer der wäßrig-alkalischen Lösungen durchgeführt, die auch zur Entwicklung eines positiv arbeitenden Photoresists verwendet werden. Dies sind z. B. wäßrige Lösungen von Natriumhydroxid, Tetramethylammoniumhydroxid, Trimethyl(hydroxyethyl)-ammoniumhydroxid, Alkaliphosphaten, -silikaten oder -carbonaten, die Netzmittel oder kleinere Mengen organischer Lösemittel enthalten können. Bei der Entwicklung werden die bei der ursprünglichen Bildbelichtung nicht vom Licht getroffenen Schichtbereiche ausgewaschen, so daß ein negatives Resistbild der Vorlage erhalten wird.

In den meisten Fällen wird das belichtete und entwickelte Resistmaterial dann mit einem Ätzmittel behandelt, wobei das Ätzmittel nur in den Nichtbildbereichen auf den Schichtträger einwirken kann. Auf diese Weise wird auf dem Schichtträger im Falle einer positiv arbeitenden Kopierschicht ein negatives Ätzbild und im Falle einer negativ arbeitenden Kopierschicht ein positives Ätzbild erzeugt.

Das nach den beschriebenen Verfahren auf dem Schichtträger erzeugte positive bzw. negative Reliefbild der Kopierschicht eignet sich für verschiedene Anwendungszwecke, u. a. als Belichtungsmaske oder als Bild bei der Herstellung von Halbleiterbauelementen in der Mikroelektronik, als Druckform für den Hoch-, Tief- oder Flachdruck sowie für die Herstellung von Nickelrotationszylindern in einem galvanischen Verfahren.

Die kommerzielle Eignung einer Kopierschicht, z. B. einer Photoresistschicht, wird u. a. nach der Strahlungsempfindlichkeit, dem Entwicklungs- und Bildkontrast, der Auflösung und der Haftung auf dem Schichtträger beurteilt.

Eine hohe Strahlungsempfindlichkeit des Gemisches ist bei der Fertigung mikroelektronischer Schaltkreise oder Bauelemente ein wesentlicher Faktor, vor allem bei der sog. "in-line"-Verarbeitung von Wafern, bei der der Durchsatz an Wafern von den am längsten dauernden Prozeßschritt bestimmt wird. Bei den bisher notwendigen relativ langen Belichtungszeiten ist der Durchsatz am Belichtungsgerät der limitierende Faktor. Vor allem bei monochromatischer Bestrahlung und bei Bestrahlung mit kürzerwelligem, aktinischem Licht sind die Taktzeiten am Belichtungsgerät zu lang, was eine zu geringe Produktionsgeschwindigkeit zur Folge hat.

Die Resistauflösung betrifft die Fähigkeit eines Photoresistsystems, auch die feinsten Linien und Zwischenräume einer für die Belichtung verwendeten Maske wiederzugeben, wobei die belichteten und entwickelten Bereiche ein hohes Maß an Kantensteilheit und -schärfe aufweisen sollen.

In vielen technischen Einsatzgebieten, insbesondere bei der Herstellung von Halbleiterelementen in der Mikroelektronik, muß der Photoresist eine besonders hohe Auflösung erreichen, denn es müssen sehr kleine Linien- und Zwischenraumbreiten (< 1 µm) wiedergeben werden. Die Fähigkeit, kleinste Details in der Größenordnung von 1 µm und darunter wiederzugeben, ist für die großtechnische Herstellung von integrierten Schaltungen auf Siliciumchips und ähnlichen Bauteilen von größter Bedeutung. Die Integrationsdichte auf einem solchen Chip läßt sich bei Verwendung photographischer Verfahren durch eine Steigerung des Auflösungsvermögens des Photoresists erhöhen.

Es ist bekannt, daß die Auflösung eines Photoresists steigt, wenn darin photoaktive Verbindungen mit mehreren strahlungsempfindlichen Resten in einem Molekül vorhanden sind, da dann der strahlungsempfindliche Anteil erhöht ist. [P. Trefonas III and B. K. Daniels, "New Principle for Image Enhancement in Single Layer Positive Photoresists", SPIE Advances in Resist Technology and Processing IV, 771 (1987), 194-210; P. Trefonas III, B. K. Daniels and R. L. Fischer, "Photoresist Design for Submicron Optical Lithography: Application of Polyphotolysis", Solid State Technology 30 (1987) 131-137].

Bei Verwendung der in den EP-A 0 244 762 und 0 244 763 genannten Mischester ist bereits eine verbesserte Auflösung festzustellen. In der DE-A 38 37 500 werden die überlegenen Eigenschaften von kernsubstituierten Naphthochinondiazidderivaten in lithographischen Anwendungen gezeigt. Ester von gegebenenfalls substituierten o-Naphthochinon-2-diazid-4-oder -5-sulfonsäuren mit Verbindungen, die drei oder mehr aromatische Hydroxygruppen besitzen, weisen jedoch häufig eine zu geringe Löslichkeit in den üblichen Lösemitteln auf, was dazu führt, daß die mit diesen Estern hergestellten Resists noch keine ausreichende Auflösung erreichen.

Es bestand daher die Aufgabe, neue Gemische mit gesteigerter Strahlungsempfindlichkeit und verbesserter Löslichkeit in den industriell verwendeten Lösemitteln zur Verfügung zu stellen.

Die Aufgabe wird gelöst durch ein Gemisch, das als strahlungsempfindliche Komponente einen Ester aus a) einer Verbindung mit 2 bis 6 aromatischen Hydroxygruppen, b) einer kernsubstituierten o-Naphthochinon-2-diazid-4-sulfonsäure (Diazoverbindung D₁) und c) einer nicht weiter substituierten o-Naphthochinon-2-diazid-4- bzw. -5-sulfonsäure (Diazoverbindung D₂) ist, wobei das molare Verhältnis von D₁:(D₂) zwischen 0,1:1 und 30:1 liegt. Die Ester und deren Herstellung sind in der gleichzeitig eingereichten Patentanmeldung P 4 111 443.4 (EP-A-0 508 269) beschrieben. Das alkalilösliche Bindemittel ist bevorzugt ein Novolak, ein Poly(vinylphenol) oder ein Poly(vinylalkylphenol).

Das strahlungsempfindliche Gemisch wird allgemein in Form einer Lösung in einem organischen Lösemittel auf ein Trägermaterial aufgebracht. Geeignete Lösemittel sind beispielsweise Glykolether, wie Ethylenglykolmonomethylether oder -monoethylether oder auch deren Acetate wie Propylenglykolmethyletheracetat, Ester wie Ethyl- oder Butylacetat, Ketone wie Methylethylketon, Cyclopentanon und Cyclohexanon sowie aromatische Kohlenwasserstoffe wie Toluol und Xylenol. Auch Gemische aus diesen Lösemitteln können verwendet werden.

Der Anteil des Bindemittels im Gemisch beträgt im allgemeinen etwa 15 bis 99 Gew.-%, bevorzugt etwa 50 bis 97 Gew.-%, ganz besonders bevorzugt etwa 63 bis 93 Gew.-%, bezogen auf das Gesamtgewicht der festen Bestandteile im strahlungsempfindlichen Gemisch.

Der Anteil der strahlungsempfindlichen Verbindung liegt bei etwa 1 bis 50 Gew.-% und bevorzugt bei etwa 3 bis 35 Gew.-%, bezogen auf das Gesamtgewicht der festen Bestandteile im Gemisch.

Zur Herstellung einer Lösung des strahlungsempfindlichen Gemisches werden das Bindemittel und die lungsempfindliche Verbindung mit so viel Lösemittel gemischt, daß der Anteil des Lösemittels etwa 40 bis 90 Gew.-%, vorzugsweise etwa 60 bis 85 Gew.-%, beträgt.

Der strahlungsempfindlichen Lösung können vor dem Aufbringen auf einen Schichtträger noch Zusätze zugegeben werden, wie z. B. Vernetzungsmittel, Farbstoffe, Verlaufmittel, Weichmacher, Haftvermittler, Entwicklungsbeschleuniger, Tenside, z. B. nicht ionische Tenside.

Als Farbstoffe geeignet sind z. B. Methylviolett 2B (C.I. 42 535), Kristallviolett (C.I. 42 555), Malachitgrün (C.I. 42 000), Viktoriablau B (C.I. 44 045), Neutralrot (C.I. 50 040), Cumarin- und Styrylfarbstoffe entsprechend der EP-A 0 070 445 bzw. der DE-A 37 35 852. Diese Farbstoffe werden in einer Menge von 1 bis 10 Gew.-%, bezogen auf das Gesamtgewicht von Bindemittel und strahlungsempfindlicher Verbindung, zugesetzt.

Verlaufmittel können in einer Menge bis zu 5 Gew.-%, bezogen auf das Gesamtgewicht von Bindemittel und strahlungsempfindlicher Verbindung, eingesetzt werden.

Geeignete Weichmacher sind z. B. Phosphorsäure-tri-(β-chlorethyl)-ester, Stearinsäure, Dicampher, Polypropylen, Acetalharze, Phenoxyharze und Alkydharze, die in Anteilen von 1 bis 10 Gew.-%, bezogen auf das Gesamtgewicht von Bindemittel und strahlungsempfindlicher Verbindung, zugesetzt werden können. Die Weichmacherzusätze verbessern die Beschichtungseigenschaften des Gemisches und ermöglichen das Auftragen in einer glatten und gleichmäßig dicken Schicht auf den Schichtträger.

Geeignete Haftvermittler zur besseren Haftung des Gemisches auf dem Träger sind spezielle siliciumorganische Verbindungen, z. B. 3-Aminopropyltriethoxysilan, in einem Anteil bis zu 4 Gew.-%, bezogen auf das Gesamtgewicht von Bindemittel und strahlungsempfindlicher Verbindung.

Als Entwicklungsbeschleuniger können aromatische Carbonsäuren oder aromatische Polyhydroxyverbindungen, wie Polyhydroxybenzophenon, Pikrin-, Nikotin- oder Nitrozimtsäure, in einem Anteil von bis zu 20 Gew.-%, bezogen auf das Gesamtgewicht von Bindemittel und strahlungsempfindlicher Verbindung, zugegeben werden. Diese Beschleuniger führen dazu, daß die Löslichkeit der strahlungsempfindlichen Schicht sowohl in den belichteten als auch in den unbelichteten Bereichen zunimmt. Sie werden deshalb bei solchen Anwendungen eingesetzt, bei denen es in erster Linie auf die Entwicklungsgeschwindigkeit ankommt. Während die belichteten Schichtbereiche durch den Zusatz von Beschleunigern vom Entwickler schneller gelöst werden, bewirken die Entwicklungsbeschleuniger gleichzeitig aber auch einen größeren Schichtverlust aus den unbelichteten Bereichen, so daß eventuell ein Kontrastverlust eintritt.

Geeignete nicht-ionische Tenside sind z. B. Polyethylenglykol-mono-nonylphenylether, -mono-octylphenylether und -mono-dinonylphenylether in einem Anteil von bis zu 10 Gew.-%, bezogen auf das Gesamtgewicht von Bindemittel und strahlungsempfindlicher Verbindung.

Geeignete Vernetzungsmittel sind in der EP-A 0 212 482 und der US-A 4 404 272 beschrieben. Diese werden im allgemeinen einem strahlungsempfindlichen Gemisch zugesetzt, das für eine negativ arbeitende Schicht, z. B. einen negativ arbeitenden Photoresist, vorgesehen ist. Es sind hauptsächlich aromatische Verbindungen mit zwei oder mehr Hydroxy- oder Alkoxymethylgruppen im Molekül, wie 1,2-Bis-hydroxymethylbenzol, 1,2-Bis-methoxymethyl-benzol, 1,2-Bis-hydroxymethyl-furan, 2,6-Bis-hydroxymethyl-4-methyl-anisol, 1,4-Bis- (a-hydroxybenzyl) -benzol, 2,5-Dimethyl-1,4-bis-hydroxymethyl-benzol, 4,4'-Bis-hydroxymethyldiphenylether, 4,4'-Dimethoxy-diphenyl, 2,6-Bis-hydroxymethyl-4-methoxy- oder -4-ethoxyphenol, 4,4'-Bis-methoxymethyl-diphenylether und Epoxykresol-Novolakharze sowie auch Alkoxymethylmelaminderivate. Besonders bevorzugt sind: 2,6-Bis-hydroxymethyl-4-methyl-, -4-ethyl-, -4-propyl-, -4-isopropyl-, -4-n-butyl-, -4-tert.-butyl-, -4-(2-phenyl-2-propyl)-phenol.

Die Vernetzungsmittel können in Anteilen von 1,5 bis 20 Gew.-%, bezogen auf den Gesamtfeststoffgehalt des strahlungsempfindlichen Gemisches, eingesetzt werden.

In Anwesenheit von Säure und bei erhöhter Temperatur werden durch diese Vernetzungsmittel die Bindemittelmoleküle "vernetzt", d.h. die strahlungsempfindliche Schicht wird gehärtet. Die für die Schichthärtung erforderliche Säure entsteht infolge der Photoreaktion der strahlungsempfindlichen Verbindung.

Das erfindungsgemäße strahlungsempfindliche Gemisch besitzt eine erhöhte Lösungsstabilität und Lagerfähigkeit. Die Auflösung ist besser als bei vergleichbaren strahlungsempfindlichen Gemischen des Standes der Technik.

Die Erfindung betrifft ferner ein strahlungsempfindliches Aufzeichnungsmaterial, bestehend im wesentlichen aus einem Schichtträger und einer strahlungsempfindlichen Schicht aus einem Gemisch der oben beschriebenen Art, sowie ein Verfahren zur Herstellung des Aufzeichnungsmaterials.

Geeignete Trägermaterialien sind beispielsweise Silicium, Aluminium oder polymere Harze, Siliciumoxid, dotiertes Siliciumoxid, Siliciumnitrid, Tantal, Kupfer, Polysilicium (Polysilicon), Keramik und Aluminium/Kupfer-Legierungen.

Zur Herstellung des erfindungsgemäßen Aufzeichnungsmaterials kann das strahlungsempfindliche Gemisch, beispielsweise ein Photoresist, nach technisch üblichen Verfahren, wie Tauchen, Sprühen und Aufschleudern, auf den Träger aufgebracht werden. Beim Aufschleudern wird der Anteil an Feststoffen in der Resistlösung so eingestellt, daß sich in Abhängigkeit von der im Einzelfall verwendeten Aufschleudervorrichtung und der für den Aufschleudervorgang angesetzten Zeitspanne eine Beschichtung in der gewünschten Dicke ergibt.

Die nach dem beschriebenen Verfahren hergestellten strahlungsempfindlichen Gemische eignen sich besonders gut zum Auftragen auf Silicium-Wafer, die eine Schicht aus Siliciumoxid tragen, wie sie bei der Herstellung von Mikroprozessoren und anderen in der Mikroelektronik verwendeten Halbleiterbauelementen verwendet werden. Ebenso kann auch ein Wafer aus Galliumarsenid, aus Aluminium mit einer Oxidschicht oder aus Silicium mit einer Schicht aus metallischem oder oxidativ nachbehandeltem Aluminium eingesetzt werden. Der Träger kann auch aus verschiedenen polymeren Harzen, insbesondere aus transparenten Polymeren, wie z. B. Polyestern, bestehen.

Nach dem Auftragen des strahlungsempfindlichen Gemisches auf den Schichtträger wird der Fest/Flüssig-Verbund einer Vortrocknung bei etwa 80 bis 105 °C unterworfen. Diese Wärmebehandlung wird so lange fortgeführt, bis das Lösemittel nahezu vollständig verdampft ist und eine dünne Schicht von etwa 1 µm auf dem Schichtträger zurückbleibt.

Der beschichtete Träger wird anschließend in bekannter Weise mit aktinischer Strahlung, insbesondere UV-Strahlung der Wellenlängen 248, 365, 405 oder 436 nm, durch geeignete Masken, Negative, Schablonen usw. bildmäßig belichtet oder der gerichteten Elektronenstrahlung oder der Strahlung eines Lasers ausgesetzt. Der Begriff "aktinische Strahlung" umfaßt sowohl den Röntgenbereich als auch elektromagnetische Strahlung im technisch anwendbaren Wellenlängenbereich von 193 bis 450 nm und Elektronenstrahlung.

Zur Entwicklung werden die bildmäßig belichteten Aufzeichnungsmaterialien in eine wäßrig-alkalische Entwicklerlösung getaucht. Häufig werden in der Technik auch Sprühentwicklungsverfahren eingesetzt.

Nach dem Herausnehmen aus der Entwicklerlösung kann man das Material einer Wärmebehandlung bzw. Einbrennbehandlung unterziehen, um die Haftung und die chemische Beständigkeit der Schicht gegen Ätzlösungen und andere Substanzen zu erhöhen. Die Wärmebehandlung nach der Entwicklung kann aus einer Ofenhärtung von Schicht und Träger bei Temperaturen unterhalb des Erweichungspunktes der Schicht bestehen.

Für industrielle Anwendungen, insbesondere bei der Herstellung von Halbleiterbauelementen auf Siliciumträgern mit einer Siliciumoxidschicht, können die entwickelten Träger mit einer gepufferten Ätzlösung auf der Basis von Flußsäure behandelt werden. Die erfindungsgemäßen Photoresistgemische sind gegen saure Ätzlösungen resistent und gewährleisten einen wirksamen Schutz der unbelichteten, mit dem Photoresistgemisch beschichteten Stellen des Trägers.

Die erfindungsgemäßen strahlungsempfindlichen Gemische eignen sich nicht nur als Photoresistgemische, sondern können auch für Druckplatten und Farbprüffolien verwendet werden.

Wird das Aufzeichnungsmaterial, das durch Beschichten eines Trägers mit dem erfindungsgemäßen Gemisch erzeugt wird und noch ein Vernetzungsmittel enthalten kann, für den negativ arbeitenden Bildumkehrprozeß eingesetzt, wird nach der bildmäßigen Belichtung eine zweite, kurzzeitige Wärmebehandlung bei einer Temperatur zwischen 90 und 150 °C durchgeführt. Während dieser Wärmebehandlung erfolgt in den belichteten Bereichen der Photoresistschicht die Härtung des Bindemittels. Die Dauer der Wärmebehandlung liegt zwischen 10 und 90 Sekunden. Nach der Wärmebehandlung und Abkühlung des Aufzeichnungsmaterials wird die Photoresistschicht entwickelt oder vorzugsweise vor der Entwicklung einer ganzflächigen UV-Bestrahlung ausgesetzt (Flutbelichtung). Als Entwickler dienen wäßrig-alkalische Lösungen, die anorganische oder quaternäre organische Basen enthalten. Sie können gepuffert sein oder zusätzliche Additive (z. B. Netzmittel) enthalten. Hierbei werden die Schichtbereiche, die bei der Bildbelichtung nicht belichtet wurden, ausgewaschen und die Schichtbereiche, die bei der Bildbelichtung belichtet wurden, nicht angegriffen (Negativprozeß). Es entsteht eine negative Reliefkopie der Belichtungsmaske.

Positiv- und Negativprozeß können auch auf einem Schichtträger kombiniert werden (photocomposing).

In den folgenden Beispielen werden die strahlungsempfindlichen Gemische und Aufzeichnungsmaterialien näher erläutert.

### Beispiele

Für den lithographischen Vergleich wurden strahlungsempfindliche Gemische formuliert. Sie enthalten ausschließlich vollständig veresterte Derivate des 2,3,4,4'-Tetrahydroxy-benzophenons (Beispiele 1 bis 6).

Verestert sind die Derivate mit 7-Methoxy-1,2-naphthochinon-2-diazid-4-sulfonsäure (D₁) und 1,2-Naphthochinon-2-diazid-4-sulfonsäure (D₂) im Molverhältnis D₁:D₂ von 0,33:1 (Beispiel 1) bzw. von 4,71:1 (Beispiel 2) . In den Vergleichsbeispielen 3, 4 und 10 sind die Hydroxybenzophenone allein mit 1,2-Naphthochinon-2-diazid-4-sulfonsäure verestert und in den Vergleichsbeispielen 5 und 6 allein mit 7-Methoxy-1,2-naphthochinon-2-diazid-4-sulfonsäure.
a) Erfindungsgemäße Gemische:
   Zu der 26%igen Lösung eines Kresol/Xylenol-Novolaks in Methoxypropanolacetat werden, bezogen auf den Novolak, 28 % bei Derivaten des Tetrahydroxybenzophenons bzw. 43 % bei Derivaten des Hexahydroxybenzophenons der photoaktiven Verbindung zugesetzt und gelöst.
b) Vergleichsbeispiele:
   Zu der unter a) genannten Novolaklösung setzt man das entsprechende Naphthochinondiazid bis zur Sättigung der Lösung zu und filtriert von ungelöstem Material ab.
   Mit diesen Resistlösungen werden Silicium-Wafer durch Aufschleudern beschichtet und die so erhaltenen Schichten auf einer Heizplatte bei 90 °C 60 Sekunden lang getrocknet. Die Schichtdicke beträgt 1,30 µm. Nach der Belichtung mit einem in der Technik üblichen Belichtungsgerät durch eine Maske, die Strukturen unterschiedlicher Dimensionen enthält, werden die Schichten einer nochmaligen Wärmebehandlung bei 100 °C 60 Sekunden lang auf der Heizplatte unterzogen. Anschließend löst man die vom Licht getroffenen Bereiche der Schicht mit einer Entwicklerlösung auf (Entwicklungszeit 60 s), so daß die nicht belichteten Flächenanteile auf der Siliciumscheibe zurückbleiben.
   Wie die folgende Tabelle zeigt, können mit den erfindungsgemäßen Gemischen wesentlich kleinere Strukturen erzeugt werden.

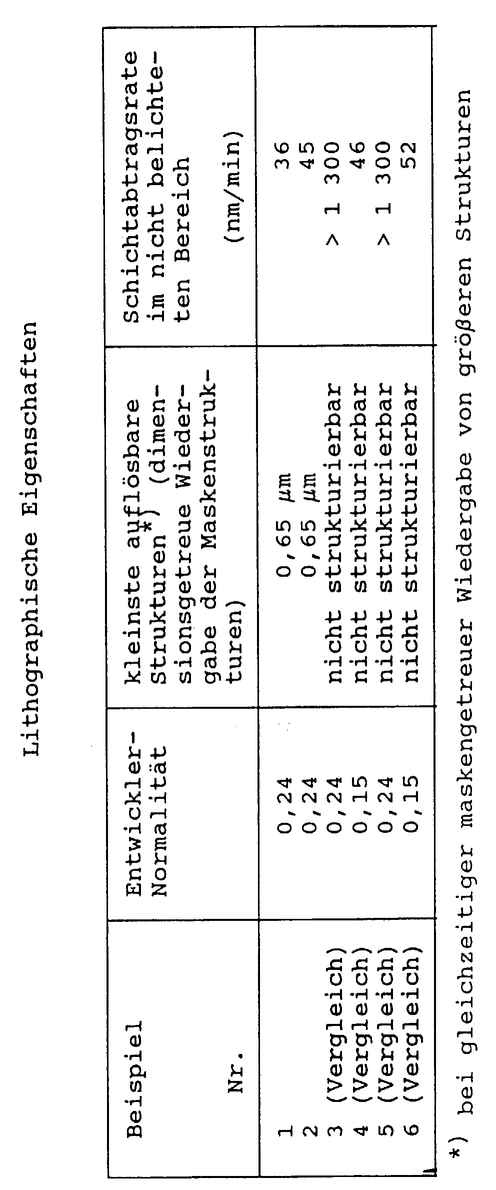

## Patentansprüche

1. Strahlungsempfindliches Gemisch, das ein in Wasser unlösliches, in wäßrig-alkalischen Lösungen jedoch lösliches, zumindest aber quellbares harzartiges Bindemittel und mindestens eine strahlungsempfindliche Verbindung enthält, dadurch gekennzeichnet, daß die strahlungsempfindliche Verbindung ein Ester aus a) einer Verbindung mit 2 bis 6 aromatischen Hydroxygruppen, b) einer kernsubstituierten o-Naphthochinon-2-diazid-4-sulfonsäure (Diazoverbindung D₁) und c) einer nicht weiter substituierten o-Naphthochinon-2-diazid-4- bzw. -5-sulfonsäure (Diazoverbindung D₂) ist, wobei das molare Verhältnis von D₁:(D₂) zwischen 0,1:1 und 30:1 liegt.

2. Strahlungsempfindliches Gemisch gemäß Anspruch 1, dadurch gekennzeichnet, daß das harzartige Bindemittel ein Novolak, ein Poly(vinylphenol) oder ein Poly(vinylalkylphenol) ist.

3. Strahlungsempfindliches Gemisch gemäß den Ansprüchen 1 oder 2, dadurch gekennzeichnet, daß das Gemisch zusätzlich Vernetzungsmittel, Farbstoffe, Verlaufmittel, Weichmacher, Haftvermittler, Entwicklungsbeschleuniger und/oder Tenside enthält.

4. Strahlungsempfindliches Gemisch gemäß einem oder mehreren der Ansprüche 1 bis 3, dadurch gekennzeichnet, daß das Bindemittel einen Anteil von 15 bis 99 Gew.-% an den festen Bestandteilen des Gemisches hat.

5. Strahlungsempfindliches Gemisch gemäß einem oder mehreren der Ansprüche 1 bis 4, dadurch gekennzeichnet, daß die strahlungsempfindliche Verbindung einen Anteil von 1 bis 50 Gew.-%, bevorzugt 3 bis 35 Gew.-%, an den festen Bestandteilen des Gemisches hat.

6. Strahlungsempfindliches Aufzeichnungsmaterial, im wesentlichen bestehend aus einem Schichtträger und einer strahlungsempfindlichen Schicht, dadurch gekennzeichnet, daß die strahlungsempfindliche Schicht im wesentlichen aus dem strahlungsempfindlichen Gemisch gemäß einem oder mehreren der Ansprüche 1 bis 5 besteht.

7. Aufzeichnungsmaterial nach Anspruch 6, dadurch gekennzeichnet, daß der Schichtträger ein Silicium- oder Galliumarsenidwafer ist, auf dem zwischen dem halbleitenden Material und der strahlungsempfindlichen Schicht noch mindestens eine weitere Schicht aufgebracht ist.

## Claims

1. A radiation-sensitive mixture containing a resinous binder which is insoluble in water, but soluble or at least swellable in aqueous alkaline solutions and at least one radiation-sensitive compound, wherein the radiation-sensitive compound is an ester of a) a compound containing 2 to 6 aromatic hydroxyl groups, b) a ring-substituted (o-naphthoquinone 2-diazide)-4-sulfonic acid (diazo compound D₁) and c) an (o-naphthoquinone 2-diazide)-4- or -5-sulfonic acid which is not further substituted (diazo compound D₂), where the D₁:D₂ molar ratio is between 0.1:1 and 30:1.

2. The radiation-sensitive mixture as claimed in claim 1, wherein the resinous binder comprises a novolak, a poly(vinylphenol) or a poly(vinylalkylphenol).

3. The radiation-sensitive mixture as claimed in claim 1 or 2, wherein the mixture additionally contains crosslinking agents, dyes, leveling agents, plasticizers, adhesion promoters, development accelerators and/or surfactants.

4. The radiation-sensitive mixture as claimed in one or more of claims 1 to 3, wherein the binder is present in a proportion of 15 to 99% by weight of the solid constituents of the mixture.

5. The radiation-sensitive mixture as claimed in one or more of claims 1 to 4, wherein the radiation-sensitive compound is present in a proportion of 1 to 50% by weight, preferably 3 to 35% by weight, of the solid constituents of the mixture.

6. A radiation-sensitive recording material which essentially consists of a layer support and a radiation-sensitive layer, wherein the radiation-sensitive layer essentially consists of the radiation-sensitive mixture as claimed in one or more of claims 1 to 5.

7. The recording material as claimed in claim 6, wherein the layer support comprises a silicon or gallium arsenide wafer to which at least one further layer is additionally applied between the semiconducting material and the radiation-sensitive layer.

## Revendications

1. Mélange sensible au rayonnement, contenant un liant résineux insoluble dans l'eau, mais soluble ou au moins gonflable dans un milieu aqueux-alcalin, et au moins un composé sensible au rayonnement, caractérisé en ce que le composé sensible au rayonnement est un ester a) d'un composé avec 2 à 6 groupes hydroxy aromatiques, b) d'un acide o-naphtoquinone-2-diazide-4-sulfonique substitué sur le noyau (composé diazoïque D₁) et c) d'un acide o-naphtoquinone-2-diazide-4-, respectivement -5-sulfonique, ne portant pas d'autres substituants (composé diazoïque D2), le rapport molaire de D1:D2 étant compris entre 0,1:1 et 30:1.

2. Mélange sensible au rayonnement selon la revendication 1, caractérisé en ce que le liant résineux est une novolaque, un poly(vinylphénol) ou un poly(vinylalkylphénol).

3. Mélange sensible au rayonnement selon l'une des revendications 1 ou 2, caractérisé en ce que le mélange comprend de plus des agents réticulants, des colorants, des agents de nivelement, des plastifiants, des agents d'accrochage, des accélérateurs de développement et/ou des agents de surface.

4. Mélange sensible au rayonnement selon l'une des revendications 1 à 3, caractérisé en ce que le liant présente une teneur de 15 à 99 % en poids en extrait sec par rapport au mélange.

5. Mélange sensible au rayonnement selon l'une des revendications 1 à 4, caractérisé en ce que le composé sensible au rayonnement présente une teneur en extrait sec de 1 à 50 % en poids, de préférence de 3 à 35 % en poids.

6. Matière d'enregistrement sensible au rayonnement constituée essentiellement d'un support de couche et d'une couche sensible au rayonnement, caractérisée en ce que la couche sensible au rayonnement est constituée essentiellement du mélange sensible au rayonnement selon une ou plusieurs des revendications 1 à 5.

7. Matière d'enregistrement selon la revendication 6, caractérisée en ce que le support de couche est une puce d'arséniure de gallium ou de silicium sur laquelle, entre la matière semiconductrice et la couche sensible au rayonnement, est déposée encore au moins une autre couche.
